# EUROPEAN PATENT APPLICATION

(11) **EP 4 287 797 A1**
(43) Date of publication of application: **06.12.2023**
(21) Application number: 22176355.0
(22) Date of filing: 31.05.2022
(51) Int. Cl.: H05K 7/20

(54) **ELECTRICAL EQUIPMENT WITH AN INTEGRATED COOLANT PUMP**

(71) Applicant: Valeo eAutomotive Germany GmbH, 91056 Erlangen (DE)
(72) Inventor: Lewandowski, Marek, 91056 C/o VSeA, Erlangen (DE)
(74) Representative: Valeo Powertrain Systems

(57) **Abstract**

The invention concerns an electrical equipment (10) comprising at least one electrical module (20), a cooling module (30) configured to dissipate heat generated by the at least one electrical module (20), the cooling module (30) having a body (31) and at least one channel (32) formed in the body (31), the at least one channel (32) being configured to circulate a coolant, the electrical equipment (10) further comprising a coolant pump (40) having a volute chamber (41) configured to receive and to out the coolant through an outlet (44) of the volute chamber (41) which is fluidly connected to the at least one channel (32), the volute chamber (41) of the coolant pump (40) being directly integrated in the body (31) of the cooling module (30).

## Description

### FIELD OF THE INVENTION

The present invention belongs to the field of electrical equipment configured to be on board an automotive vehicle, such as an electric vehicle (EV) or a hybrid vehicle (HV).

In particular, the present invention relates to the cooling and to the integration of electrical equipment, such as an inverter.

### BACKGROUND OF THE INVENTION

As is known, an electric or a hybrid automotive vehicle presents an electric drive comprising a rotary electric machine which need to be supplied with electric power, for instance by a high voltage power supply battery, to deliver a mechanical power in order to ensure the propulsion of the vehicle. The supply of electric power to the rotary electric machine is performed by means of electrical equipment, especially an inverter configured to convert a direct current voltage coming from the high-voltage power supply battery into an alternating current voltage so as supply the rotary electric machine with the AC voltage.

Moreover, the electric drive generates heat in service, and thus requires to be efficiently cooled such that each component of the electric drive operates in the adequate temperature range. Doing so further improves the in-service life of the electric drive. In that aim, the vehicle comprises a cooling system such that to dissipate heat generated by the electric drive.

The cooling system commonly comprises a water pump configured to assist the flowing of a coolant, for instance water, from a radiator and towards the electrical equipment to be cooled. The coolant then recirculates from the electrical equipment back into the radiator, such that to be cooled. The water pump especially has an impeller configured to rotate within a volute chamber. The coolant is sucked through an inlet near the center of the water pump and towards the impeller. Then, the centrifugal force, induced by the spinning of the impeller, thrusts the coolant outside the volute chamber, and towards the electrical equipment such that to absorb heat generated by the electrical equipment.

In this context, the main objective of the present invention is thus to provide an electrical equipment for an electric vehicle with an improved compacity and which is easier to produce.

### SUMMARY OF THE INVENTION

More specifically, the present invention relates to an electrical equipment comprising at least one electrical module, a cooling module configured to dissipate heat generated by the at least one electrical module. The cooling module has a body and at least one channel formed in the body, the at least one channel being configured to circulate a coolant.

Then, the electrical equipment further comprises a coolant pump having a volute chamber configured to receive and to expel the coolant through an outlet of the volute chamber which is fluidly connected to the at least one channel. The volute chamber of the coolant pump is directly integrated in the body of the cooling module.

Thus, compared a conventional solution, in which the coolant pumping function is performed by a coolant pump as a separate unit from the electrical equipment, and which would then be fluidly connected to a cooling circuit of the electrical equipment, the present invention gives the substantial advantage of reducing the number of components and simplifying the manufacturing process for realizing both the coolant pumping function and the electrical equipment. The present invention, by integrating the coolant pump directly with the electrical equipment, also provides the gain of allowing to perform more easily the routing of hydraulic circuits of the coolant pump and of the cooling module, and to render the electric drive safer and more reliable.

The coolant pump notably comprises an impeller configured to rotate around a rotation axis within the volute chamber such that to propel the coolant towards the outlet of the volute chamber. Advantageously, the axis of rotation of the impeller is substantially perpendicular to the cooling module. Thus, the outlet of the volute chamber may advantageously be oriented substantially in a same plane as the cooling module such that the coolant is directly and more easily fed to the at least one channel of the cooling module, limiting a potential pressure drop of the coolant.

Advantageously, the cooling module having an inlet and an outlet, the inlet of the cooling module and the outlet of the cooling module are arranged on a same face of the cooling module. This allows for an easier integration of the electrical equipment.

Advantageously, the at least one electrical module and the coolant pump are located on a same side of the cooling module. Thus, the compactness of the electrical equipment is improved.

Advantageously, the electrical equipment comprises a casing configured to come against the cooling module such that to cover the at least one electrical module and the coolant pump.

In a preferred manner, the coolant pump is an electric coolant pump. The electric coolant pump has a pump motor configured to rotate the impeller. The pump motor is notably controlled by an electronic control unit such that to control the flow or the pressure of the coolant. The electric coolant pump allows thus to better monitor and adjust the flow of the coolant to have a more efficient temperature control of the electrical equipment.

Advantageously, the casing of the electrical equipment covers the pump motor, which further eases the integration of the coolant pump in the electrical equipment.

Advantageously, the electrical equipment comprises an electronic control unit configured to command both the electric coolant pump and the at least one electrical module. The invention allows thus to reduce the number electrical components, such as the amount of printed circuit board, and to have fewer electrical connections to implement.

Advantageously, the electrical equipment forms an inverter configured to convert a direct current voltage coming from a high-voltage power supply battery into an alternating current voltage so as supply a rotary electric machine with the alternating current voltage.

Another aspect of the invention is an electric drive comprising the rotary electric machine and the inverter as previously described. The rotary electric machine may be a poly-phase electric motor, especially a three-phase electric motor, supplied with a three-phase AC voltage.

A further aspect of the invention is an electric of a hybrid vehicle, comprising the electric drive as described previously for driving the vehicle. The vehicle may comprise the high-voltage power supply battery, preferably a rechargeable battery for providing the DC voltage to the inverter, if applicable.

These and other objects, features, aspects and advantages of the present invention will become apparent to those skilled in the art from the following detailed description, which, taken in conjunction with the annexed drawings, discloses preferred embodiments of the present invention.

### BRIEF DESCRIPTION OF THE DRAWINGS

The invention will be better understood on reading the description that follows, and by referring to the appended drawings given as non-limiting examples, in which identical references are given to similar objects and in which:
Figure 1 is a schematic diagram of a cut view of an example of an electrical equipment according to an embodiment of the invention;
Figure 2 is a schematic diagram of an automotive electric or hybrid vehicle comprising the electrical equipment according to an embodiment of the invention.

### DETAILED DESCRIPTION

Selected embodiments of the present invention will now be explained with reference to the drawings. It will be apparent to those skilled in the art from this disclosure that the following descriptions of the embodiments of the present invention are provided for illustration only and not for the purpose of limiting the invention as defined by the appended claims and their equivalents.

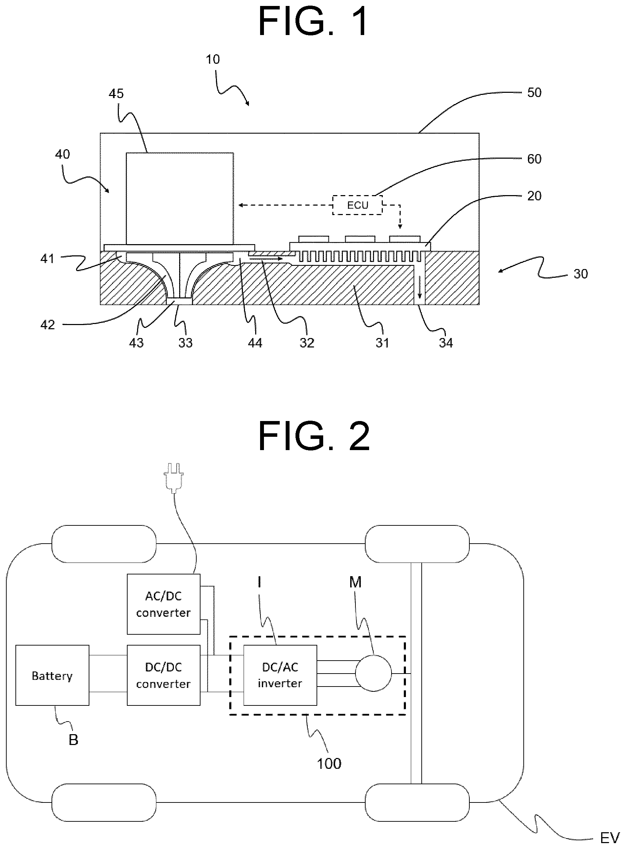

In reference to Figure 2, an aspect of the invention is an electric vehicle or a hybrid electric automotive vehicle EV comprising wheels and an electric drive 100 configured to drive at least indirectly at least one of the wheels of the vehicle. The vehicle especially comprises a high-voltage power supply battery B, preferably a rechargeable battery, for providing electric power to the electric drive 100.

The electric drive 100 according to a further aspect of the invention notably comprises a rotary electric machine M and an inverter I configured to be electrically connected to the rotary electric machine M. The inverter I is especially configured to convert a direct current (DC) voltage coming from the high-voltage power supply battery B into an alternating current (AC) voltage in order to supply a stator of the rotary electric machine M with AC voltage. Besides, the rotary electric machine M may be a poly-phase electric motor, especially a three-phase electric motor, supplied with a three-phase AC voltage.

The electric drive 100 preferably forms a fully integrated assembly. The term fully integrated shall be interpreted as the rotary electric machine, the inverter, and potentially the transmission, of the vehicle are advantageously arranged in a compact manner. Some components, especially electrical or non-electrical components, may advantageously be shared within the electric drive. For example, there may be less electrical conductors in such an electric drive. As another example, the electric drive 100 may comprise a housing made of a plurality of pieces attached together such that to cover the components of the electric drive. The fully integrated assembly presents thus the advantage of having a more compact electric drive, which has fewer components, is simpler and less costly to produce.

The invention also concerns an electrical equipment, especially a power converter such as the inverter as previously described. Figure 1 illustrates schematically the electrical equipment 10 according to this aspect of the invention. The electrical equipment 10 comprises at least one electrical module 20. In the context of the electrical equipment being the inverter, the at least one electrical module 20 especially corresponds to a power stage of the inverter. The power stage notably has a plurality of switching elements configured to ensure the transmission of electric power between the electric power supply and the rotary electric machine. For instance, in the case of the inverter supplying a three-phase electric motor with electric power, the inverter may comprise three power stages, each power stage corresponding to one of the three-phases of the electric motor.

The electrical equipment 10 also comprises a cooling module 30 configured to dissipate heat generated by the at least one electrical module 20. The cooling module 30 has a body 31 and at least one channel 32 formed in the body 31. The at least one channel 32 is configured to circulate a coolant configured to absorb heat generated by the at least one electrical module 20. The flow path of the coolant is especially represented by arrows in Figure 1. The coolant is preferably a cooling medium, for instance water, or a mixture of water and glycol, although other types of coolant are possible, if appropriate.

Then, the electrical equipment 10 further comprises a coolant pump 40, for instance a water pump, configured to assist the flowing of the coolant towards the at least one electrical module 20 to be cooled. The coolant may notably come from a radiator before entering the coolant pump 40 and being thrusted by the coolant pump towards the at least one electrical module 20. Then, after absorbing heat generated by the electrical module 20, the coolant may flow from the cooling module 30 into a hydraulic circuit, which recirculates the coolant back to the radiator and then back to the coolant pump 40.

The coolant pump 40 has a volute chamber 41 and an impeller 42 configured to rotate within the volute chamber 41 around a rotation axis within the volute chamber 41 such that to flow the coolant out of the volute chamber 41 and towards the at least one channel 32 of the cooling module 30.

The volute chamber 41 is configured to receive the coolant through an inlet 43 of the volute chamber 41 and to expel the coolant through at least one outlet 44 of the volute chamber 41 which is fluidly hydraulically connected to the at least one channel 32 of the cooling module 30. More precisely, the coolant is sucked through the inlet 43 of the volute chamber 41 near the center of the coolant pump 40 and towards the impeller 42. Then, the centrifugal force, induced by the spinning of the impeller 42, thrusts the coolant outside the volute chamber 41 through the at least one outlet 44 of the volute chamber 41 located on the circumference of the volute chamber 41. The volute chamber 41 may comprise several outlets if appropriate. Here, only one outlet will be considered, although it does not convey a limitation of the invention. The coolant is thus accelerated by the coolant pump towards the at least one channel 32 of the cooling module.

The volute chamber 41 of the coolant pump 40 is directly integrated in the body 31 of the cooling module 30 such that the coolant flows from the outlet 44 of the volute chamber 41 and directly into the at least one channel 32 for absorbing heat generated by the at least one electrical module 20. More specifically, the coolant pump has a hydraulic circuit configured to flow the coolant, the hydraulic circuit comprising the volute chamber. Then, in the invention, the hydraulic circuit of the coolant pump is advantageously directly formed in the mass of the cooling module 30.

In a conventional solution, the coolant pumping function is performed by a coolant pump as a separate unit from the electrical equipment, and which would then be fluidly connected to a cooling circuit of the electrical equipment through hoses, pipes or similar channels. Thus, compared to the previously described conventional solution, the present invention gives the substantial advantage of reducing the number of components and simplifying the manufacturing process for realizing both the coolant pumping function and the electrical equipment. The related costs may also advantageously be reduced.

In fact, the invention allows to avoid using a separate housing for the coolant pump, as the housing of the coolant pump would directly form a same piece with the cooling module. Therefore, there is no more need of mounting the housing of the coolant pump elsewhere in the vehicle, nor of mounting hoses between the coolant pump and the electrical equipment to be cooled, which reduces the mounting operations and eases the manufacturing of the electric drive. Moreover, the number of sealing areas are also advantageously reduced thanks to the invention.

Moreover, the invention permits to conveniently set-up several outlets of the coolant pump, and to adapt a hydraulic circuit of the cooling module (i.e., the at least one channel) to these several outlets, such that to efficiently cool the electrical equipment. This would have been tedious in the previously described conventional solution. More generally, the invention makes it easier to design the cooling module for an efficient cooling of the electrical equipment, and to make the hydraulic circuit of the coolant pump and the hydraulic circuit of the cooling module cooperate with each other.

Besides, the integration of the hydraulic circuit of the coolant pump to the cooling module of the electrical equipment allows the hydraulic circuit of the coolant pump to benefit from a residual heat of the electrical equipment. More specifically, the body of the cooling module may store some residual heat generated by the at least one electrical module. Then, this residual heat may ease the flow of the coolant, especially in case of a cold start of the coolant flowing. If the coolant is semi-frozen, thanks to the invention, the coolant shall liquefy faster compared to the previously described conventional solution, which should advantageously improve the service life of the coolant pump.

In a nutshell, the present invention, by integrating the coolant pump directly with the electrical equipment, provides the substantial gain of allowing to perform more easily the routing of the hydraulic circuits of the coolant pump and of the cooling module, and to simplify the manufacturing and to enhance the compactness and the safety of the electric drive.

The cooling module 30 will now be further detailed. The body 31 of the cooling module 30 notably presents a parallelepiped shape. Within the body 31, the at least one channel 32 may advantageously be designed such that to flow the coolant in an efficient manner, depending on the physical arrangement of electrical components of the at least one electrical module 20 to be cooled.

For example, represented in Figure 1, the at least one channel 32 may have a partial opening oriented towards the at least one electrical module 20. Then, in this configuration, the at least one electrical module 20 may have a base plate, forming an interface between the electrical components of the at least one electrical module 20, and the partial opening of the at least one channel 32. Then, the base plate, which would be directly in contact with the coolant, acts as a heat exchanger between the respective electrical components and the coolant flowing within the at least one channel 32. The base plate may notably have fins projecting from the base plate and configured to be immersed in the coolant such that to improve the cooling efficiency.

As another example, not represented in the Figures, the at least one channel 32 may be entirely formed inside the body 31 of the cooling module 30. Then, the at least one electrical module 20 is configured to come against the body 31 of the cooling module 30. In this configuration, the at least one electrical module 20 is configured to be cooled by conduction through a mechanical contact between the at least one electrical module and the body 31 of the cooling module 30. This configuration presents the advantage of limiting the number of sealings within the electrical equipment but provides a less efficient cooling compared to the solution using a base plate directly in contact with the coolant, as previously described.

Besides, the at least one channel 32 may comprise a plurality of channels, that may intersect with one another, if appropriate.

It is important to note that the design of the at least one channel 32 and is not restricted to the previously described configurations, which are merely examples of how the cooling of the at least one electric module 20 may be realized by the cooling module.

Besides, the axis of rotation of the impeller 42 may advantageously be substantially perpendicular to the cooling module 30. It can be noted that the outlet 44 of the volute chamber 41 is generally oriented within a plane substantially perpendicular to the axis of rotation of the impeller 42. Thus, the outlet 44 of the volute chamber 41 may advantageously be oriented substantially in a same plane as the cooling module 30 such that the coolant is directly and more easily fed to the at least one channel 32 of the cooling module 30, limiting a potential pressure drop of the coolant.

The cooling module 30 especially has an inlet 33 and an outlet 34, that may be arranged on peripheral faces of the cooling module 30. The inlet 33 of the cooling module 30 is preferably formed near the inlet 43 of the volute chamber 41 of the coolant pump 40. Although, the inlet 33 of the cooling module 30 may be formed on another side of the cooling module 30 given that a flow path is formed such that to connect the inlet 33 of the cooling module 30 with the inlet 43 of the volute chamber 41.

The inlet 33 of the cooling module 30 and the outlet 34 of the cooling module 30 may preferably be arranged on a same face of the cooling module 30, notably to ease the integration of the electrical equipment 10 within the electric drive.

In a preferred manner, the at least one electrical module 20 and the coolant pump 40 are located on a same side of the cooling module 30. Thus, the compacity of the electrical equipment is improved.

The electrical equipment 10 may further comprise a casing 50 configured to come against the cooling module 30 such that to cover the at least one electrical module 20 and the coolant pump 40. In other words, the casing 50 and the cooling module 30 form together a housing of the electrical equipment 10 enclosing both the at least one electrical module 20 and the coolant pump 40.

In a preferred embodiment of the invention, the coolant pump 40 is an electric coolant pump. The electric coolant pump especially has a pump motor 45 configured to rotate the impeller 42. The pump motor 45 may notably be supplied with a DC electric power, for instance with a 12V electric supply line.

Then, the pump motor 45 is notably controlled by an electronic control unit (ECU) such that to control the flow or the pressure of the coolant. For instance, a sensing system may measure a representative temperature of the electrical equipment or of another equipment in contact with the coolant and send the temperature data to the ECU. The ECU would then activate, deactivate, or adjust the flow of the coolant to achieve a desired temperature range. The electric coolant pump allows thus to better monitor and adjust the flowing of the coolant to have a more efficient temperature control of the electrical equipment.

Using an electric coolant pump allows to further ease the integration of the coolant pump in the electrical equipment. In fact, the casing 50 of the electrical equipment may advantageously cover the pump motor 45.

Preferably, the electrical equipment 10 may comprise a same electronic control unit (ECU) 60 configured to command both the electric coolant pump and the at least one electrical module 20. The invention allows thus to reduce the number electrical components, such as the amount of printed circuit board (PCB), and to have fewer electrical connections to implement, especially fewer external electrical connections within the vehicle.

Although embodiments have been described with reference to a number of illustrative embodiments thereof, it should be understood that numerous other modifications and embodiments can be devised by those skilled in the art that will fall within the spirit and scope of the principles of this disclosure.

## Claims

1. An electrical equipment (10) comprising:
- at least one electrical module (20);
- a cooling module (30) configured to dissipate heat generated by the at least one electrical module (20), the cooling module (30) having a body (31) and at least one channel (32) formed in the body (31), the at least one channel (32) being configured to circulate a coolant,
**characterized in that** the electrical equipment (10) further comprises a coolant pump (40) having a volute chamber (41) configured to receive and to out the coolant through an outlet (44) of the volute chamber (41) which is fluidly connected to the at least one channel (32), the volute chamber (41) of the coolant pump (40) being directly integrated in the body (31) of the cooling module (30).

2. The electrical equipment (10) as claimed in the claim 1, the coolant pump (40) comprising an impeller (42) configured to rotate around a rotation axis within the volute chamber (41) such that to flow the coolant towards the outlet (44) of the volute chamber (41), wherein the axis of rotation of the impeller (42) is substantially perpendicular to the cooling module (30).

3. The electrical equipment (10) as claimed in any of the preceding claims, wherein the at least one electrical module (20) and the coolant pump (40) are located on a same side of the cooling module (30).

4. The electrical equipment (10) as claimed in the previous claim, comprising a casing (50) configured to come against the cooling module (30) such that to cover the at least one electrical module (20) and the coolant pump (40).

5. The electrical equipment (10) as claimed in any of the preceding claims, wherein the coolant pump (40) is an electric coolant pump.

6. The electrical equipment (10) as claimed in the previous claim combined with claim 4, the electric coolant pump having the impeller (42) and a pump motor (45) configured to rotate the impeller (42), the casing (50) of the electrical equipment (10) covering the pump motor (45).

7. The electrical equipment (10) as claimed in the claim 5 or 6, comprising an electronic control unit (60) configured to command both the electric coolant pump and the at least one electrical module (20).

8. The electrical equipment (10) as claimed in any of the preceding claims, forming an inverter (I) configured to convert a direct current voltage coming from a high-voltage power supply battery (B) into an alternating current voltage so as supply a rotary electric machine (M) with the alternating current voltage.

9. An electric drive (100) comprising the electrical equipment (10) according to any of the preceding claims and the rotary electric machine (M).

10. An electric or a hybrid vehicle (EV) comprising the electric drive (100) according to the previous claim.
